# EUROPÄISCHE PATENTSCHRIFT

(11) **EP 1 143 531 B1**
(45) Veröffentlichungstag und Bekanntmachung des Hinweises auf die Patenterteilung: **23.01.2008**
(21) Anmeldenummer: 01106187.6
(22) Anmeldetag: 14.03.2001
(51) Int. Cl.: H01L 39/12, H01F 6/00

(54) **Permanentmagnet aus einem supraleitenden keramischen Material**
Permanent magnet comprising superconducting ceramic material
Aimant permanent en matériau supraconducteur céramique

(30) Priorität: 16.03.2000 DE 10013832
(43) Veröffentlichungstag der Anmeldung: 10.10.2001
(73) Patentinhaber: Leibniz-Institut für Festkörper- und Werkstoffforschung Dresden e.V., 01069 Dresden (DE)
(72) Erfinder: Krabbes, Gernot, 01809 Heidenau (DE); Fuchs, Günter, 01237 Dresden (DE); Stöver, Gudrun, 01239 Dresden (DE); Verges, Peter, 01237 Dresden (DE); Shlyk, Larissa, 01705 Freital (DE)
(74) Vertreter: Rauschenbach, Dieter

(56) Entgegenhaltungen:
- EP-A- 0 562 618
- US-A- 5 306 700
- SCHATZLE P ET AL: "YBCO/Ag bulk material by melt crystalization for cryomagnetic applications" IEEE TRANSACTIONS ON APPLIED SUPERCONDUCTIVITY IEEE USA, Bd. 9, Nr. 2, Juni 1999 (1999-06), Seiten 2022-2025, XP002315821 ISSN: 1051-8223
- KRABBES G ET AL: "Zn doping of YBa2Cu3O7 in melt textured materials: peak effect and high trapped fields" PHYSICA C, NORTH-HOLLAND PUBLISHING, AMSTERDAM, NL, Bd. 330, Nr. 3-4, 15. März 2000 (2000-03-15), Seiten 181-190, XP004190701 ISSN: 0921-4534
- GRUSS S ET AL: "Trapped fields beyond 11 T in bulk YBa2Cu3O7-[delta] material" APPLIED SUPERCONDUCTIVITY 1999. PROCEEDINGS OF EUCAS 1999, THE FOURTH EUROPEAN CONFERENCE ON APPLIED SUPERCONDUCTIVITY IOP PUBLISHING BRISTOL, UK, Bd. 1, 2000, Seiten 115-118 vol.1, XP009043171 ISBN: 0-7503-0694-7
- KRABBES G ET AL: "Reproducible generation of the peak effect in large YBCO-monoliths by Zn doping" APPLIED SUPERCONDUCTIVITY 1999. PROCEEDINGS OF EUCAS 1999, THE FOURTH EUROPEAN CONFERENCE ON APPLIED SUPERCONDUCTIVITY IOP PUBLISHING BRISTOL, UK, Bd. 1, 2000, Seiten 59-62 vol.1, XP009043170 ISBN: 0-7503-0694-7
- FUCHS G ET AL H: "Different limitations of trapped fields in melt-textured YBCO" APPLIED SUPERCONDUCTIVITY 1999. PROCEEDINGS OF EUCAS 1999, THE FOURTH EUROPEAN CONFERENCE ON APPLIED SUPERCONDUCTIVITY IOP PUBLISHING BRISTOL, UK, Bd. 1, 2000, Seiten 111-114 vol.1, XP009043172 ISBN: 0-7503-0694-7
- HU A ET AL: "Melt processing and flux pinning behaviors of (Nd0.33Sm0.67)Ba2Cu3O7-[delta] superconductors" APPLIED SUPERCONDUCTIVITY 1999. PROCEEDINGS OF EUCAS 1999, THE FOURTH EUROPEAN CONFERENCE ON APPLIED SUPERCONDUCTIVITY IOP PUBLISHING BRISTOL, UK, Bd. 1, 2000, Seiten 131-134 vol.1, XP009043169 ISBN: 0-7503-0694-7
- KRABBES G ET AL: "Modified melt crystallization processes for improved RE-123 based bulk materials (RE=Y, Nd)" APPLIED SUPERCONDUCTIVITY, PERGAMON PRESS, EXETER, GB, Bd. 6, Nr. 2-5, Februar 1998 (1998-02), Seiten 61-76, XP004140868 ISSN: 0964-1807
- HU A ET AL: "Enhanced flux pinning in Nd0.33Sm0.67Ba2Cu3O7-d melt-processed superconductors by Ar postannealing" APPLIED PHYSICS LETTERS, AMERICAN INSTITUTE OF PHYSICS. NEW YORK, US, Bd. 75, Nr. 2, 12. Juli 1999 (1999-07-12), Seiten 259-261, XP012024002 ISSN: 0003-6951
- KRABBES G ET AL: "YBCO - monoliths with trapped fields more than 14 T and peak effect" PHYSICA C, PROC. INT. CONF. MAT. MECH. SUPERCOND. AND HTS VI, HOUSTON, USA, Bd. 341-348, November 2000 (2000-11), Seiten 2289-2292, XP004316286 AMSTERDAM, NL ISSN: 0921-4534
- BICHILE G K ET AL: "INFLUENCE OF NICKEL SUBSTITUTION ON FLUX PINNING AND CRITICAL CURRENTS IN YBA2CU3O7-" CRYOGENICS, IPC SCIENCE AND TECHNOLOGY PRESS LTD. GUILDFORD, GB, Bd. 31, Nr. 9, 1. September 1991 (1991-09-01), Seiten 833-838, XP000258961 ISSN: 0011-2275
- PAVATE V ET AL: "Identification and correlation of microstructural defects with flux pinning in Ni-doped melt textured YBa2Cu3O7-[delta]" APPLIED PHYSICS LETTERS USA, Bd. 65, Nr. 2, 11. Juli 1994 (1994-07-11), Seiten 246-248, XP002315819 ISSN: 0003-6951
- MIZUTANI U ET AL: "Synthesis of c-axis-oriented Sm123 superconductors and their performance as superconducting permanent magnets" PHYSICA C, PROC. NINTH JAPAN-US WORKSHOP ON HTS, 13-15.10.1999, Bd. 335, Nr. 1-4, Juni 2000 (2000-06), Seiten 92-96, XP004208117 AMSTERDAM, NL ISSN: 0921-4534
- OKA T ET AL: "Construction of a 2-5 T class superconducting magnetic field generator with use of an Sm123 bulk superconductor and its application to high-magnetic field demanding devices" PHYSICA C, PROC. NINTH JAPAN-US WORKSHOP ON HTS, 13-15.10.1999, Bd. 335, Nr. 1-4, Juni 2000 (2000-06), Seiten 101-106, XP004208119 AMSTERDAM,NL ISSN: 0921-4534
- HU A ET AL: "Melt processing and high performance of binary (Nd,Sm)-Ba-Cu-O superconductors" SUPERCONDUCTOR SCIENCE & TECHNOLOGY IOP PUBLISHING UK, Bd. 12, Nr. 5, Mai 1999 (1999-05), Seiten 301-307, XP002315820 ISSN: 0953-2048
- PETZOW G.; EFFENBERG G.: 'Ternary Alloys, Vol. 2', 1988, VCH * Seiten 60,61,68 *

## Beschreibung

Die Erfindung betrifft einen Permanentmagnet aus einem supraleitenden keramischen Material.

Permanentmagnete, die supraleitende keramische Materialien enthalten, sind bereits bekannt. Es ist auch bekannt, dass durch Zusätze zu supraleitenden Verbindungen, insbesondere Cupraten der Zusammensetzung REₙAEₘ(Cu₁₋ₓMₓ)₃O_{7±x}, M = Al, Fe, Zn, Mg, Ni, worin RE für eines oder mehrere der Elemente Y, La, Nd und anderen Lanthaniden steht, die kritischen Temperaturen T_{c} des Überganges in den supraleitenden Zustand negativ beeinflusst werden, indem sie zu ungünstigen niedrigen Temperaturen verschoben werden.

Kürzlich war festgestellt worden, dass trotz Erniedrigung von T_{c} eine Verbesserung der kritischen Stromdichte insbesondere in Magnetfeldern erreicht werden kann, wenn einem supraleitenden Körper aus Cupratmaterialien Zn-Ionen in Mengen bis 1 Masse% zugesetzt werden (Krabbes, G. et al., Physica C **330** (2000) 181).

Zylindrische Körper von Cupratmaterialien können als Permanentmagnete mit hoher remanenter Induktion B₀ verwendet werden (Oka, T. et al., 9^{th} Japan-US-Workshop on High-T_{c} Superconductors, Yamanashi (Japan) 13.-15. Oktober 1999). Der Erreichung extrem hoher Remanenzinduktion steht entgegen, dass das spröde keramische Material infolge der beim Magnetisierungsprozess auftretenden hohen Lorentzkräfte bricht. Das trifft insbesondere für supraleitende Körper zu, denen Zn-Ionen zugesetzt wurden. Dem Mangel kann durch Anbringen einer mechanischen Verstärkung in Form eines von außen aufgeschrumpften Ringes nur teilweise abgeholfen werden.

Andererseits ist bekannt, dass duktile Ausscheidungen in einer keramischen Matrix zur Erhöhung der Bruchzähigkeit führen, weil durch sie die Ausbreitung von Mikrorissen, der wesentliche Schädigungsmechanismus, gehemmt wird. Durch Erzeugung von Ag-Ausscheidungen bzw. Einschlüssen in supraleitenden Keramiken konnte tatsächlich die erreichbare Remanenzinduktion auf über 9 T gesteigert werden (Schätzle, P. et al., IEEE Transactions Appl. Supercond. 9 (1999) 2022). In Verbindung mit einer mechanischen Verstärkung nimmt die Remanenzinduktion an der Oberfläche des Magneten Werte über 11 T an. Leider sinkt aber durch diese Veränderung des Materials die kritische Stromdichte j_{c}, so dass so hohe Felder erst bei etwa 20 K erzeugt werden können (Fuchs, G. et al., Appl. Phys. Lett. (2000), 76, 2107).

Der Erfindung liegt die Aufgabe zugrunde, einen Permanentmagnet aus einem supraleitenden keramischen Verbundmaterial so auszubilden, dass eine extrem hohe Remanenzinduktion von mehr als 10 T bei Temperaturen oberhalb 20 K ohne Schädigung des Materials aufgeprägt werden kann.

Diese Aufgabe wird auf der Basis eines Permanentmagneten aus supraleitendem keramischem Verbundmaterial gelöst, bei dem in einer texturierten supraleitenden keramischen Matrix mindestens eine nichtsupraleitende feindisperse Phase enthalten ist, wobei die Matrix aus mindestens einer supraleitenden Phase der Zusammensetzung REₙAEₘ(Cu₁₋ₓMₓ)₃O_{7+Δ} besteht, mit 1 < n < 1,5 und 2 > m > 1,5 und -0,8 < Δ < 0,2 und mit AE = Ba, Sr und/oder Ca. Die nichtsupraleitende feindisperse Phase ist dabei ein Cuprat der Zusammensetzung (RE₂BaCuO₅)ₐ mit a = 1 oder 2. In der Matrix und in der nichtsupraleitenden feindispersen Phase steht RE für die Elemente aus der Gruppe der Lanthaniden und für Y.

Gemäß der Erfindung enthält die supraleitende Phase für M mindestens eines der Elemente Li, Mg, Zn, Ni und Pd mit 2·10⁻⁴ < x < 2·10⁻² und in dem Verbundmaterial sind Einschlüsse aus Ag und/oder Ag-Legierungen verteilt, wobei der Anteil dieser Einschlüsse 2 bis 25 Masse% des supraleitenden keramischen Verbundmaterials beträgt.

Vorteilhaft können in dem Verbundmaterial neben den Einschlüssen aus Ag und/oder Ag-Legierungen weitere Einschlüsse vorhanden sein, die aus Metalloxiden bestehen.

Das RE in der Matrix kann ein Gemisch aus 2 oder 3 Elementen aus der Gruppe Y, La, Ce, Nd, Sm, Eu, Gd, Tb, Ho, Er und Yb sein.

AE kann Ba oder eine Mischung aus Ba und mindestens einem der Elemente Ca und Sr sein, wobei das molare Verhältnis (Ca,Sr) zu Ba < 0,2 ist.

Vorteilhaft ist es, wenn die Matrix aus YBa₂Cu_{3-y}Zn_{y}O₇ mit Ag-Einschlüssen oder aus YBa₂Cu_{3-y}Zn_{y}O_{6,97} mit Ag-Einschlüssen besteht, wobei 0,01 < y < 0,03 ist.

Vorteile ergeben sich auch, wenn der Permanentmagnet die Form eines Zylinders hat, auf dessen Umfang ein Metallring zur Verfestigung aufgeschrumpft ist.

Die erfindungsgemäßen Permanentmagnete zeichnen sich durch wesentlich verbesserte Eigenschaften gegenüber den bekannten derartigen Permanentmagneten aus. Besonders vorteilhaft ist, dass ein remanentes Feld oberhalb 10 T bereits bei 40 K erreichbar ist, ohne dass es zu einer Schädigung des Materials kommt. Diese Eigenschaftsverbesserung wird insbesondere durch die Zusätze von Li, Mg, Ni ,Pd, Zn oder einer Mischung von diesen Elementen sowie die gleichzeitig vorhandenen Einschlüsse von metallischem Silber erreicht.

Nachstehend ist die Erfindung an Hand von Ausführungsbeispielen näher erläutert. In den zugehörigen Zeichnungen zeigen:

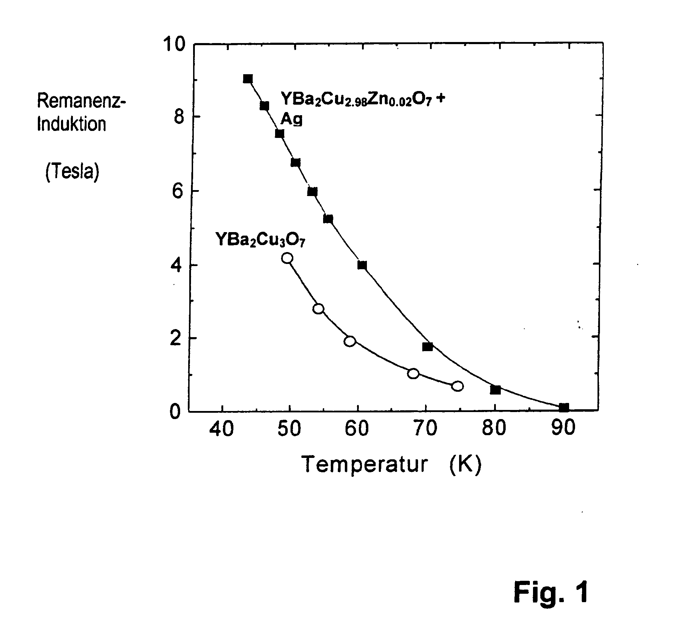

- Fig. 1:: ein Diagramm mit dem temperaturabhängigen Verlauf der Remanenzinduktion an einem erfindungsgemäßen Permanentmagnet, der YBa₂Cu_{2,98}Zn_{0,02}O₇ + Ag enthält im Vergleich zu einem bekannten Permanentmagnet, der YBa₂Cu₃O₇ + Ag (ohne erfindungsgemäße Zusätze) enthält,

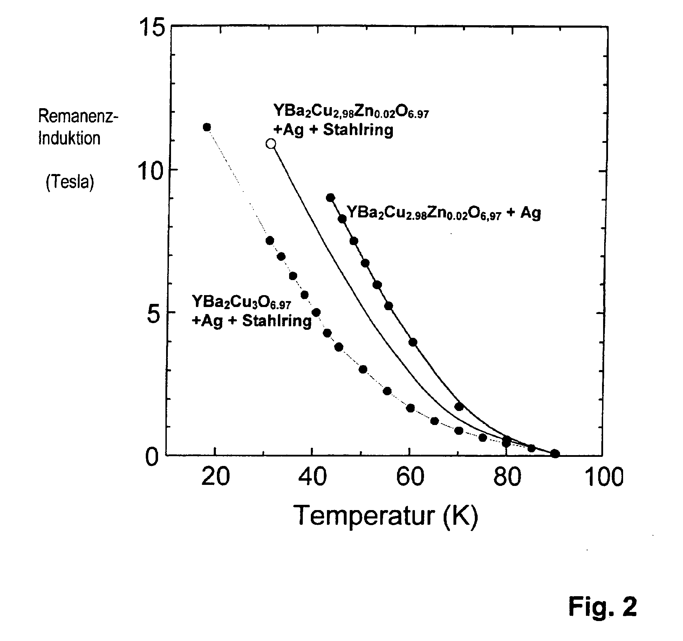

- Fig. 2:: ein Diagramm mit dem temperaturabhängigen Verlauf der Remanenzinduktion an zwei Ausführungsmöglichkeiten eines erfindungsgemäßen Permanentmagneten, der YBa₂Cu_{2,98}Zn_{0,02}O_{6,97} +Ag enthält, im Vergleich zu einem bekannten, mit einem Stahlring mechanisch verstärkten Permanentmagnet, der YBa₂Cu₃O_{6,97} + Ag (ohne erfindungsgemäße Zusätze) enthält.

### Beispiel 1

Das Beispiel betrifft einen aus einem supraleitenden Verbundmaterial bestehenden Permanentmagnet, bei dem in einer supraleitenden Matrix aus YBₐ2Cu₂,₉₈Zn₀,₀₂O₇ Körner einer nichtsupraleitenden Phase aus Y₂BaCuO₅ sowie Einschlüsse aus Ag enthalten sind.

Die Herstellung dieses Permanentmagneten erfolgt in folgenden vier wesentlichen Verfahrensschritten:
a) Herstellung einer Pulvermischung und Verpressen der Pulvermischung zu einem Formkörper,
b) Durchführung eines Schmelztexturierungsprozesses an dem Formkörper,
c) Finale Formgebung
d) Magnetisierungsprozess zum Aufprägen einer Remanenzinduktion.

Im Schritt a) wird zunächst ein Pulver der Ausgangsverbindung YBa₂Cu_{2,98}Zn_{0,02}O₇ aus einem Gemisch aus Y₂O₃, BaCO₃, CuO und ZnO in entsprechenden molaren Anteilen hergestellt durch dreimaliges Erhitzen auf 940 °C mit nacholgender Zerkleinerung und Homogenisierung des Reaktionsproduktes. Dem so erhaltenen Pulver werden Y₂O₃-Pulver und Ag-Pulver zugemischt in folgendem molaren Verhältnis:
1 YBa₂Cu_{2,98}Zn_{0,02}O₇ : 0,36 Y₂O₃ :1 Ag.

Die erhaltene Pulvermischung wird zu einem zylindrischen Formkörper mit einem Durchmesser von 20 mm gepresst.

Zur Vorbereitung der Schmelztexturierung im Verfahrensschritt b) wird auf die Stirnfläche des Formkörpers mittig ein Keim aus einkristallinem SmBa₂Cu₃O₇ mit seiner kristallographischen c-Achse parallel zur Zylinderachse aufgesetzt. Bei der anschließenden Schmelztexturierung wird der Formkörper an Luft wie folgt wärmebehandelt:
1. Aufheizen mit 400K/h auf 1020°C
2. Schnelles Abkühlen auf 980°C
3. Kristallisation durch Abkühlen mit 1 K/h auf 940°C
4. Oxidation des Formkörpers in O₂ bei 380°C über 100 h.

Im Verfahrensschritt c) wird der Formkörper mechanisch auf das gewünschte Maß geschnitten, geschliffen und poliert.

Schließlich wird der Formkörper im Verfahrensschritt d) unter Anwendung eines Kühlmittels auf eine Temperatur T = 77 K abgekühlt. Bei dieser Temperatur wird dann dem Formkörper in einem Magnetisierungszyklus eine Remanenzinduktion aufgeprägt.

Die dabei erreichte, aufgeprägte Remanenzinduktion ist im Vergleich zu den Werten eines bekannten supraleitenden Permanentmagneten gleicher Abmessungen, der YBa₂Cu₃O₇ + Ag (ohne erfindungsgemäße Zusätze) enthält, um 40% auf 520 mT erhöht.

### Beispiel 2

Das Beispiel betrifft einen aus einem supraleitenden Verbundmaterial bestehenden Permanentmagnet, bei dem in einer supraleitenden Matrix aus YBa₂Cu₂,₉₈Zn_{0,02}O₇ Einschlüsse aus Ag neben einer nichtsupraleitenden Phase aus Y₂BaCuO₅ enthalten sind, wobei die nichtsupraleitende Phase Y₂BaCuO₅ feindispers vorliegt, indem die Vergröberung der Körner dieser Phase während des Herstellungsprozesses durch zusätzliche Zugabe von geringen Mengen Pt unterdrückt wurde.

Ein zylindrischer Formkörper von 30 mm Durchmesser wird hergestellt in analoger Weise wie in den Verfahrensschritten a) bis c) des Beispiels 1 beschrieben, jedoch wird der Mischung zusätzlich Pt-Pulver zugesetzt im Verhältnis 0,5 g Pt : 100 g YBa₂Cu_{2,98}Zn_{0,02}O_{6,97}.

Abschließend wird der Formkörper im Verfahrensschritt d) unter Anwendung eines Kühlmittels auf eine Temperatur T unterhalb der kritischen Temperatur T_{c} K abgekühlt. Bei dieser Temperatur wird dann dem Formkörper in einem Magnetisierungszyklus eine Remanenzinduktion aufgeprägt.

Die dabei erreichte, aufgeprägte Remanenzinduktion ist in Fig. 1 in der rechten Kurve in Abhängigkeit von der Temperatur T dargestellt. Im Vergleich zu den Werten eines bekannten supraleitenden Permanentmagneten aus YBa₂Cu₃O₇ + Ag, dessen Remanenzinduktion in der linken Kurve der Fig. 1 dargestellt ist, zeigt der erfindungsgemäße Permanentmagnet im Bereich zwischen 75 K und 50 K in vorteilhafter Weise eine um 70% höhere Remanenzinduktion.

### Beispiel 3

Analog wie in den Verfahrensschritten a) bis c) der Beispiele 1 und 2 beschrieben wird ein Formkörper vom Durchmesser 30 mm mit der Ausgangszusammensetzung
1 YBa₂Cu₂,₉₈Zn_{0,02}O_{6,97} + 1 Ag + 0.36 Y₂O₃
unter Zusatz von 0,5 g Pt je 100 g YBa₂Cu_{2,98}Zn_{0,02}O_{6,97} hergestellt.

Im Verfahrensschritt c) wird die Mantelfläche des Formkörpers so durch Schleifen bearbeitet, dass der Zylinder in einen Stahlring eingeführt werden kann. Der verbleibende Spalt zwischen Formkörper und Stahlring wird mit Epoxidharz unter Anwendung einer Vakuumimprägnierung, bei der Lufteinschlüsse durch Anlegen eines Unterdruckes entfernt werden, ausgefüllt.

Im Verfahrensschritt d) sorgt dann beim Abkühlen von 300 K auf eine Temperatur unterhalb 92 K der im Vergleich zu Stahl geringere thermische Ausdehnungskoeffizient senkrecht zur kristallographischen c-Achse des YBa₂Cu₃O₇ dafür, dass der supraleitende Formkörper in radialer Richtung komprimiert wird. Diese kompressive Vorspannung kompensiert die während des Aufmagnetisierens entstehende Zugspannung, so dass höhere Remanenzinduktionen erreichbar sind als ohne Stahlring. Die maximale Remanenzinduktion erreicht so an der Zylinderstirnfläche 11 T, wie aus der mittleren Kurve in Fig. 2 ersichtlich ist. Dieser Maximalwert entspricht nahezu demjenigen eines herkömmlichen supraleitenden Permanentmagneten, der YBa₂Cu₃O₇ + Ag enthält und dessen Werte in der linken Kurve in Fig. 2 dargestellt sind, jedoch wird der Maximalwert beim erfindungsgemäßen Permanentmagnet schon bei 32 K erreicht und damit vorteilhaft bei einer um 10 K höheren Temperatur als beim herkömmlichen Material.

Die rechte Kurve in Fig. 2 zeigt die mit dem beispielgemäßen Material ohne Stahlring erreichten Werte.

### Beispiel 4 (fällt nicht unter den Schutzbereich der Patentansprüche)

Herkömmliches YBa₂Cu₃O₇ Pulver wird mit NiO intensiv gemischt, wobei das Verhältnis 1 mol YBa₂Cu₃O₇ : 0,01 mol NiO beträgt. Anschließend werden, wie in den Beispielen 1 und 2, Y₂O₃ und Pt zugemischt, wobei die Verhältnisse 1 mol YBa₂Cu₃O₇ : 0,36 mol Y₂O₃ : 0,015 mol Pt eingehalten werden. Die weitere Verarbeitung erfolgt wie im Beispiel 1, wobei sich ein Körper mit einer supraleitenden Matrix bildet, in der Cu partiell durch Ni ersetzt ist.

Der damit erhaltene supraleitende Permanentmagnet besitzt im Bereich zwischen 75 K und 50 K gegenüber herkömmlichen supraleitenden Permanentmagneten ohne erfindungsgemäße Zusätze bei gleicher Größe eine um 40% höhere Remanenzinduktion.

### Beispiel 5

Bei diesem Beispiel wird zunächst ein Pulver der Zusammensetzung YBa₂Cu_{2,985}Li_{0,015}O₇ aus einem Gemisch von Y₂O₃, BaCO₃, CuO und Li₂CO₃ in entsprechenden molaren Anteilen wie im Schritt a) des Beispiels 1 beschrieben hergestellt. Unter Zusatz von Y₂O₃ und Pt und Ag im molaren Verhältnis
YBa₂Cu₂,₉₈₅Li_{0,015}O_{6,97}: Ag : 0,36 Y₂O₃ : 0,015 Pt
werden daraus zylinderförmige Rohlinge vom Durchmesser 35 mm gepreßt, die anschließend wie im Beispiel 1 beschrieben zu supraleitenden Permanentmagneten weiterverarbeitet werden, welche im Bereich zwischen 75 K und 50 K eine um 60% höhere Remanenzinduktion besitzen im Vergleich zu herkömmlichen supraleitenden Permanentmagneten, die YBa₂Cu₃O₇ und Ag ohne erfindungsgemäße Zusätze enthalten.

## Patentansprüche

1. Permanentmagnet aus supraleitendem keramischem Verbundmaterial, bei dem in einer texturierten supraleitenden keramischen Matrix mindestens eine nichtsupraleitende feindisperse Phase enthalten ist, wobei die Matrix aus mindestens einer supraleitenden Phase der Zusammensetzung REₙAEₘ(Cu₁₋ₓMₓ)₃O_{7+Δ} besteht, mit 1 < n < 1,5 und 2 ≥ m > 1,5 und -0,8 < Δ < 0,2 und mit AE = Ba, Sr und/oder Ca, und wobei die nichtsupraleitende feindisperse Phase ein Cuprat der Zusammensetzung (RE₂BaCuO₅)ₐ mit a = 1 oder 2 ist, und wobei in der Matrix und in der nichtsupraleitenden feindispersen Phase RE für die Elemente aus der Gruppe der Lanthaniden und für Y steht, **dadurch gekennzeichnet, dass** die supraleitende Phase für M mindestens eines der Elemente Li, Mg, Zn, Ni und Pd mit 2•10⁻⁴ < x < 2•10⁻² enthält, und dass in dem Verbundmaterial Einschlüsse aus Ag und/oder Ag-Legierungen verteilt sind, wobei der Anteil dieser Einschlüsse 2 bis 25 Masse% des supraleitenden keramischen Verbundmaterials beträgt.

2. Permanentmagnet nach Anspruch 1, **dadurch gekennzeichnet, dass** in dem Verbundmaterial neben den Einschlüssen aus Ag und/oder Ag-Legierungen weitere Einschlüsse vorhanden sind, die aus Metalloxiden bestehen.

3. Permanentmagnet nach Anspruch 1, **dadurch gekennzeichnet, dass** in der Matrix das RE ein Gemisch aus 2 Elementen aus der Gruppe Y, La, Ce, Nd, Sm, Eu, Gd, Tb, Ho, Er und Yb ist.

4. Permanentmagnet nach Anspruch 1, **dadurch gekennzeichnet, dass** in der Matrix das RE ein Gemisch aus 3 Elementen aus der Gruppe Y, La, Ce, Nd, Sm, Eu, Gd, Tb, Ho, Er und Yb ist ist.

5. Permanentmagnet nach einem der Ansprüche 1 bis 5, **dadurch gekennzeichnet, dass** AE = Ba ist.

6. Permanentmagnet nach einem der Ansprüche 1 bis 5, **dadurch gekennzeichnet, dass** AE eine Mischung aus Ba und mindestens einem der Elemente Ca und Sr ist, wobei das molare Verhältnis (Ca,Sr) zu Ba < 0,2 ist.

7. Permanentmagnet nach Anspruch 1, **dadurch gekennzeichnet, dass** die Matrix aus YBa₂Cu_{3-y}Zn_{y}O₇ mit Ag-Einschlüssen oder aus YBa₂Cu_{3-y}Zn_{y}O_{6,97} mit Ag-Einschlüssen besteht, und wobei 0,01 < y < 0,03 ist.

8. Permanentmagnet nach einem der Ansprüche 1 bis 7, **dadurch gekennzeichnet, dass** er die Form eines Zylinders hat und **dass** auf den Umfang ein Metallring zur Verfestigung aufgeschrumpft ist.

## Claims

1. Permanent magnet made of superconducting ceramic compoite material, in which at least one non-superconducting finely disperse phase is contained in a textured superconducting ceramic matrix, wherein the matrix consists of at least one superconducting phase having the composition REₙAEₘ(Cu₁₋ₓMₓ)₃O_{7+Δ}, with 1 ≤ n < 1.5 and 2 ≥ m > 1.5 and -0.8 < Δ < 0.2 and with AE = Ba, Sr and/or Ca, and wherein the non-superconducting finely disperse phase is a cuprate having the composition (RE₂BaCuO₅)ₐ with a = 1 or 2, and wherein RE in the matrix and in the non-superconducting finely disperse phase stands for the elements of the lanthanide group and for Y, **characterized in that** the superconducting phase contains at least one of the elements Li, Mg, Zn, Ni and Pd for M with 2·10⁻⁴ < x < 2·10⁻², and **in that** inclusions of Ag and/or Ag alloys are distributed in the composite material, the proportion of these inclusions being from 2 to 25 mass% of the superconducting ceramic composite material.

2. Permanent magnet according to Claim 1, **characterized in that** further inclusions, which consist of metal oxides, are also present in the composite material besides the inclusions of Ag and/or Ag alloys.

3. Permanent magnet according to Claim 1, **characterized in that** the RE in the matrix is a mixture of 2 elements from the group Y, La, Ce, Nd, Sm, Eu, Gd, Tb, Ho, Er and Yb.

4. Permanent magnet according to Claim 1, **characterized in that** the RE in the matrix is a mixture of 3 elements from the group Y, La, Ce, Nd, Sm, Eu, Gd, Tb, Ho, Er and Yb.

5. Permanent magnet according to one of Claims 1 to 4, **characterized in that** AE = Ba.

6. Permanent magnet according to one of Claims 1 to 5, **characterized in that** AE is a mixture of Ba and at least one of the elements Ca and Sr, the molar ratio of (Ca,Sr) to Ba being < 0.2.

7. Permanent magnet according to Claim 1, **characterized in that** the matrix consists of YBa₂Cu_{3-y}Zn_{y}O₇ with Ag inclusions or YBa₂Cu_{3-y}ZnyO_{6.97} with Ag inclusions, and 0.01 < y < 0.03.

8. Permanent magnet according to one of Claims 1 to 7, **characterized in that** it has the shape of a cylinder, and **in that** a metal ring for fastening is shrunk onto the circumference.

## Revendications

1. Aimant permanent en matériau composite céramique supraconducteur, dans lequel au moins une phase finement dispersée non supraconductrice est contenue dans une matrice céramique supraconductrice texturée, dans lequel la matrice se compose d'au moins une phase supraconductrice présentant la composition REₙAEₘ(Cu₁₋ₓmₓ)₃O_{7+Δ}, où on a 1 ≤ n < 1,5 et 2 ≥ m > 1,5 et -0,8 < Δ < 0,2 et où en a AE = Ba, Sr et/ou Ca, et dans lequel la phase finement dispersée non supraconductrice est un cuprate présentant la composition (RE₂BaCuO₅)ₐ avec a = 1 ou 2, et dans lequel, dans la matrice et dans la phase finement dispersée non supraconductrice, RE représente les éléments du groupe des lanthanides et Y, **caractérisé en ce que** la phase supraconductrice contient pour M au moins un des éléments Li, Mg, Zn, Ni et Pd avec 2·10⁻⁴ < x < 2·10⁻², et **en ce que** des inclusions d'Ag et/ou d'alliages d'Ag sont réparties dans le matériau composite, dans lequel la proportion de ces inclusions s'élève à 2 à 25 % en masse du matériau composite céramique supraconducteur.

2. Aimant permanent selon la revendication 1, **caractérisé en ce que** d'autres inclusions, qui se composent d'oxydes métalliques, sont présentes dans le matériau composite, en plus des inclusions d'Ag et/ou d'alliages d'Ag.

3. Aimant permanent selon la revendication 1, **caractérisé en ce que** le RE dans la matrice est un mélange de 2 éléments du groupe Y, La, Ce, Nd, Sm, Eu, Gd, Tb, Ho, Er et Yb.

4. Aimant permanent selon la revendication 1, **caractérisé en ce que** le RE dans la matrice est un mélange de 3 éléments du groupe Y, La, Ce, Nd, Sm, Eu, Gd, Tb, Ho, Er et Yb.

5. Aimant permanent selon l'une quelconque des revendications 1 à 4, **caractérisé en ce que** AE = Ba.

6. Aimant permanent selon l'une quelconque des revendications 1 à 5, **caractérisé en ce que** AE est un mélange de Ba et d'au moins un des éléments Ca et Sr, dans lequel le rapport molaire (Ca, Sr) à Ba est < 0,2.

7. Aimant permanent selon la revendication 1, **caractérisé en ce que** la matrice est composée de YBa₂Cu_{3-y}Zn_{y}O₇ avec des inclusions d'argent (Ag) ou de YBa₂Cu_{3-y}Zn_{y}O_{6,97} avec des inclusions d'argent (Ag), et dans lequel 0,01 < y < 0,03.

8. Aimant permanent selon l'une quelconque des revendications 1 à 7, **caractérisé en ce qu'**il a la forme d'un cylindre et **en ce qu'**un anneau métallique est fretté sur sa périphérie pour le renforcer.
